# EUROPÄISCHE PATENTANMELDUNG

(11) **EP 4 202 691 A1**
(43) Veröffentlichungstag der Anmeldung: **28.06.2023**
(21) Anmeldenummer: 22207368.6
(22) Anmeldetag: 15.11.2022
(51) Int. Cl.: G06F 11/36, G06F 11/22

(54) **VERFAHREN UND SYSTEM ZUM BESTIMMEN EINER KOMPATIBILITÄT VON SYSTEMPARAMETERN**

(30) Priorität: 27.12.2021 DE 102021006367
(71) Anmelder: dSPACE GmbH, 33102 Paderborn (DE)
(72) Erfinder: Werth, Matthias, 33102 Paderborn (DE); Bomert, Andreas, 33102 Paderborn (DE); Becke, Daniel, 33102 Paderborn (DE)

(57) **Zusammenfassung**

Die Erfindung betrifft ein computerimplementiertes Verfahren und System zum Bestimmen einer Kompatibilität von Systemparametern (12, 14, 24, 26) für eine Testausführung eines virtuellen Tests einer Vorrichtung (8) zur zumindest teilweisen autonomen Führung eines Kraftfahrzeugs, umfassend ein Anwenden (S2) eines regelbasierten Algorithmus (A) auf den zumindest einen ersten Systemparameter (12) zum Bestimmen einer Kompatibilität des zumindest einen ersten Systemparameters (12) zu zumindest einem weiteren Systemparameter (14) aus einer Gruppe aufweisend das zu testende System (10a), die Testumgebung (10b), das Testsystem (10c), das Testszenario (10d) und/oder den zu testenden Fahrzeugtyp (10e), wobei der regelbasierte Algorithmus (A) die Kompatibilität auf Basis einer den virtuellen Test der Vorrichtung (8) zur zumindest teilweisen autonomen Führung des Kraftfahrzeugs ausführenden und/oder Testdaten bereitstellenden Hardware- und/oder Softwarekomponente (16) bestimmt.

## Beschreibung

Die vorliegende Erfindung betrifft ein computerimplementiertes Verfahren zum Bestimmen einer Kompatibilität von Systemparametern für eine Testausführung eines virtuellen Tests einer Vorrichtung zur zumindest teilweisen autonomen Führung eines Kraftfahrzeugs.

Die vorliegende Erfindung betrifft des Weiteren ein System zum Bestimmen einer Kompatibilität von Systemparametern für eine Testausführung eines virtuellen Tests einer Vorrichtung zur zumindest teilweisen autonomen Führung eines Kraftfahrzeugs.

### Stand der Technik

Fahrassistenzsysteme wie z.B. ein adaptiver Geschwindigkeitsregler und/oder Funktionen für das hochautomatisierte Fahren können mithilfe diverser Überprüfungsmethoden verifiziert bzw. validiert werden. Dabei können insbesondere Simulationen verwendet werden.

Zur Erstellung von Testszenarien für Simulationen ist die Durchführung von Testfahrten erforderlich. Die hierdurch gewonnenen Sensordaten werden sodann in ein logisches Szenario abstrahiert. Eingangsdaten sind dabei Rohdaten, also Sensordaten aus realen Messfahrten im Sinne von Aufzeichnungen von Radarechos, 3D-Punktewolken aus Lidarmessungen und Bilddaten oder virtuell erzeugte Sensordaten von Radar-, LiDAR-, Ultraschall- und/oder Kamerasensoren.

Für eine Testausführung werden neben dem Test selbst unterschiedliche Elemente benötigt. Dazu gehören zumindest ein zu testendes System, eine Testumgebung sowie ein Testsystem.

Das zu testende System beschreibt dabei ein zu testendes Element, z.B. eine ECU-Software. Die Testumgebung beschreibt die Umgebung, in der das zu testende System getestet wird und das Testsystem beschreibt das System auf dem der Test durchgeführt wird. Beispiele für das Testsystem sind HIL- oder SIL-Systeme, welche z.B. auf einem Ausführungsknoten in der Cloud ausführbar sind.

Da es in der Regel unterschiedliche bzw. mehrere zu testende Systeme, Testumgebungen und Testsysteme gibt, kann es zu der Situation kommen, dass nicht jede Kombination erwünscht oder gar möglich ist.

Im Falle einer Fehlkonfiguration eines Tests, bei welchem beispielsweise eine inkompatible Kombination aus zu testendem System, Testumgebung und Testsystem verwendet wird, kann es in der Folge zu einer fehlerhaften Testausführung in Verbindung mit einem Testabbruch kommen. Hierdurch werden Rechenzeit und/oder Rechenressourcen unnötigerweise gebunden sowie vermeidbare Kosten verursacht.

Demzufolge besteht ein Bedarf, bestehende Verfahren zur Konfiguration einer Testausführung eines virtuellen Tests einer Vorrichtung zur zumindest teilweisen autonomen Führung eines Kraftfahrzeugs dahingehend zu verbessern, dass fehlerhafte Testausführungen aufgrund von Fehlkonfigurationen vermieden werden.

Es ist daher Aufgabe der Erfindung, ein Verfahren zur Konfiguration einer Testausführung eines virtuellen Tests einer Vorrichtung zur zumindest teilweisen autonomen Führung eines Kraftfahrzeugs vorzusehen, welches eine fehlerfreie Konfigurierbarkeit der Testausführung ermöglicht.

### Offenbarung der Erfindung

Die Aufgabe wird erfindungsgemäß durch ein computerimplementiertes Verfahren zum Bestimmen einer Kompatibilität von Systemparametern für eine Testausführung eines virtuellen Tests einer Vorrichtung zur zumindest teilweisen autonomen Führung eines Kraftfahrzeugs mit den Merkmalen des Patentanspruchs 1 gelöst.

Des Weiteren wird die Aufgabe erfindungsgemäß durch ein System zum Bestimmen einer Kompatibilität von Systemparametern für eine Testausführung eines virtuellen Tests einer Vorrichtung zur zumindest teilweisen autonomen Führung eines Kraftfahrzeugs mit den Merkmalen des Patentanspruchs 15 gelöst.

Die Erfindung betrifft ein computerimplementiertes Verfahren zum Bestimmen einer Kompatibilität von Systemparametern für eine Testausführung eines virtuellen Tests einer Vorrichtung zur zumindest teilweisen autonomen Führung eines Kraftfahrzeugs.

Das Verfahren umfasst ein Bereitstellen einer vorerfassten Selektion oder Selektieren zumindest eines, ein zu testendes System, eine Testumgebung, ein Testsystem, ein Testszenario und/oder einen zu testenden Fahrzeugtyp für die Testausführung des virtuellen Tests bezeichnenden ersten Systemparameters.

Das Verfahren umfasst ferner ein Anwenden eines regelbasierten Algorithmus auf den zumindest einen ersten Systemparameter zum Bestimmen einer Kompatibilität des zumindest einen ersten Systemparameters zu zumindest einem weiteren Systemparameter aus einer Gruppe aufweisend das zu testende System, die Testumgebung, das Testsystem, das Testszenario und/oder den zu testenden Fahrzeugtyp, wobei der regelbasierte Algorithmus die Kompatibilität auf Basis einer den virtuellen Test der Vorrichtung zur zumindest teilweisen autonomen Führung des Kraftfahrzeugs ausführenden und/oder Testdaten bereitstellenden Hardware- und/oder Softwarekomponente bestimmt.

Darüber hinaus umfasst das Verfahren ein Ausgeben des zumindest einen weiteren Systemparameters, zu welchem die Kompatibilität mit dem zumindest einen ersten Systemparameter besteht.

Die Erfindung betrifft ein System zum Bestimmen einer Kompatibilität von Systemparametern für eine Testausführung eines virtuellen Tests einer Vorrichtung zur zumindest teilweisen autonomen Führung eines Kraftfahrzeugs.

Das System umfasst Mittel zum Bereitstellen einer vorerfassten Selektion oder Selektieren zumindest eines, ein zu testendes System, eine Testumgebung, ein Testsystem, ein Testszenario und/oder einen zu testenden Fahrzeugtyp für die Testausführung des virtuellen Tests bezeichnenden ersten Systemparameters.

Des Weiteren umfasst das System Mittel zum Anwenden eines regelbasierten Algorithmus auf den zumindest einen ersten Systemparameter zum Bestimmen einer Kompatibilität des zumindest einen ersten Systemparameters zu zumindest einem weiteren Systemparameter aus einer Gruppe aufweisend das zu testende System, die Testumgebung, das Testsystem, das Testszenario und/oder den zu testenden Fahrzeugtyp, wobei der regelbasierte Algorithmus die Kompatibilität auf Basis einer den virtuellen Test der Vorrichtung zur zumindest teilweisen autonomen Führung des Kraftfahrzeugs ausführenden und/oder Testdaten bereitstellenden Hardware- und/oder Softwarekomponente bestimmt.

Das System umfasst darüber hinaus Mittel zum Ausgeben des zumindest einen weiteren Systemparameters, zu welchem die Kompatibilität mit dem zumindest einen ersten Systemparameter besteht.

Eine Idee der Erfindung ist es, durch Bestimmen der Kompatibilität des zumindest einen ersten Systemparameters zu zumindest einem weiteren Systemparameter aus einer Gruppe aufweisend das zu testende System, die Testumgebung, das Testsystem, das Testszenario und/oder den zu testenden Fahrzeugtyp eine fehlerfreie Konfigurierbarkeit der Testausführung zu ermöglichen, da zur Testausführung lediglich kompatible Komponenten verwendet werden.

Ein regelbasierter Algorithmus bzw. ein regelbasiertes System ist ein wissensbasiertes System, in dem regelbasiertes Schließen stattfindet. Regelbasierte Systeme bestehen i.d.R. aus einer Datenbank von Fakten, der Faktenbasis einer Menge von Regeln, der Regelbasis, einem Kontrollsystem mit Regelinterpreter, auch Inferenzmaschine genannt.

Der erfindungsgemäße regelbasierte Algorithmus fragt zum Bestimmen der Kompatibilität des zumindest einen ersten Systemparameters zu zumindest einem weiteren Systemparameter eine Datenbank ab, in welcher eine Kompatibilitätsdefinition des zumindest einen ersten Systemparameters zu den weiteren Systemparametern hinterlegt ist.

Unter Kompatibilität ist im Kontext der vorliegenden Erfindung zu verstehen, dass der zumindest eine erste Systemparameter im Rahmen einer Testausführung eines virtuellen Tests einer Vorrichtung zur zumindest teilweisen autonomen Führung eines Kraftfahrzeugs mit dem zumindest einem weiteren Systemparameter verwendbar ist, ohne dass es zu einem Testabbruch aufgrund nicht zusammenpassender bzw. inkompatibler Hardware- und/oder Softwarekomponenten kommt.

Weitere Ausführungsformen der vorliegenden Erfindung sind Gegenstand der weiteren Unteransprüche und der nachfolgenden Beschreibung unter Bezugnahme auf die Figuren.

Gemäß einer bevorzugten Weiterbildung der Erfindung ist vorgesehen, dass das zu testende System ein computerimplementiertes Verfahren zur Durchführung des virtuellen Tests der Vorrichtung zur zumindest teilweisen autonomen Führung des Kraftfahrzeugs ist und die Testumgebung durch Software- und/oder Hardwarebestandteile der Testumgebung gebildet ist. Somit kann in vorteilhafter Weise ein effektives Testen des zu testenden Systems in der Testumgebung durchgeführt werden.

Gemäß einer weiteren bevorzugten Weiterbildung der Erfindung ist vorgesehen, dass die den virtuellen Test der Vorrichtung zur zumindest teilweisen autonomen Führung des Kraftfahrzeugs ausführende und/oder Testdaten bereitstellende Hardware- und/oder Softwarekomponente ein Sensortyp, insbesondere ein Kamerasensor, ein Radarsensor, ein LiDAR-Sensor, ein Ultraschallsensor, ein Regensensor und/oder ein Helligkeitssensor, eine Prozessorart, insbesondere eine CPU oder GPU, und eine Art des Testsystems ist. Die Kompatibilitätsprüfung stellt somit in vorteilhafter Weise sicher, dass das zu testende System unter Verwendung dafür geeigneter Hardware- und/oder Softwarekomponenten getestet wird.

Gemäß einer weiteren bevorzugten Weiterbildung der Erfindung ist vorgesehen, dass das zu testende System, die Testumgebung, das Testsystem, das Testszenario und/oder der zu testende Fahrzeugtyp jeweils durch eine Mehrzahl von Kategorien von Systemkomponenten und/oder Systemeigenschaften definiert sind, wobei jede dem zu testenden System, der Testumgebung, dem Testsystem, dem Testszenario und/oder dem zu testenden Fahrzeugtyp zugeordnete Kategorie von Systemkomponenten und/oder Systemeigenschaften zumindest eine die Systemkomponente und/oder die Systemeigenschaft identifizierende Bezeichnung, insbesondere eine alphabetische und/oder numerische Bezeichnung, aufweist.

Die Bezeichnung ermöglicht somit eine einheitliche Benennung der entsprechenden Systemkomponenten, sodass für unterschiedliche Benutzer eine einfache Verständlichkeit und Handhabbarkeit der Testausführung gegeben ist.

Die Bezeichnung ist im Sinne einer Annotierung, eines Labels bzw. eines Tags zu verstehen. Die Systemparameter werden somit durch die alphabetische und/oder numerische Bezeichnung bzw. Tag annotiert. Die Bezeichnung beschreibt hierbei einen Sensortyp, welcher z.B. in Verbindung mit einem zu testenden System verwendbar bzw. zu diesem kompatibel ist. Ebenso kann beispielsweise eine Graphikprozessorart, z.B. eine spezifische GPU beschrieben werden, die in Verbindung mit einem zu testenden System verwendbar bzw. zu diesem kompatibel ist.

Die Mehrzahl von Kategorien kategorisieren das zu testende System, die Testumgebung, das Testsystem, das Testszenario und/oder den zu testenden Fahrzeugtyp in Systemkomponenten und/oder Systemeigenschaften.

Systemkomponenten können z.B. durch eine verwendbare Sensorart, insbesondere einen Kamerasensor, einen Radarsensor, einen LiDAR-Sensor, einen Ultraschallsensor, einen Regensensor und/oder einen Helligkeitssensor und und/oder einen verwendbaren Prozessor- bzw. Graphikprozessortyp kategorisiert werden. Systemeigenschaften können z.B. ein Energieverbrauch und/oder eine Rechen- bzw. Datenverarbeitungsleistung der Systemkomponenten sein.

Um eine Kompatibilität von zwei Systemparametern bewerten zu können, wird daher definiert in welchen Kategorien die Tags bzw. Bezeichnungen der beiden Systemparameter zusammenpassen bzw. kompatibel sein müssen.

Gemäß einer weiteren bevorzugten Weiterbildung der Erfindung ist vorgesehen, dass eine Kompatibilität des zumindest einen ersten Systemparameters zu dem zumindest einen, weiteren Systemparameter durch Übereinstimmung zumindest einer, die Systemkomponente und/oder die Systemeigenschaft identifizierenden ersten Bezeichnung mit einer zweiten, die Systemkomponente und/oder die Systemeigenschaft identifizierenden zweiten Bezeichnung gegeben ist. Die Kompatibilität kann somit über entsprechende Abhängigkeiten der Bezeichnungen von Systemparametern erreicht werden.

Gemäß einer weiteren bevorzugten Weiterbildung der Erfindung ist vorgesehen, dass das zu testende System eine Verfügbarkeit vorgegebener Rechenressourcen und/oder Sensortypen erfordert. Ein Beispiel für Rechenressourcen kann hierbei eine vorgegebene Grafikkarte sein.

Gemäß einer weiteren bevorzugten Weiterbildung der Erfindung ist vorgesehen, dass in Reaktion auf das Ausgeben des zumindest einen, weiteren Systemparameters durch den regelbasierten Algorithmus, zu welchem eine Kompatibilität mit dem zumindest einen ersten Systemparameter besteht, zumindest ein zweiter Systemparameter aus der Gruppe der weiteren Systemparameter für die Testausführung des virtuellen Tests selektiert wird. Somit kann in vorteilhafter Weise eine weitere Eingrenzung der Systemparameter einer spezifischen Testkonfiguration ermöglicht werden.

Gemäß einer weiteren bevorzugten Weiterbildung der Erfindung ist vorgesehen, dass der regelbasierte Algorithmus auf den bereitgestellten und/oder selektierten zumindest einen ersten Systemparameter und den selektierten zumindest einen zweiten Systemparameter für die Testausführung des virtuellen Tests zum Bestimmen einer Kompatibilität des zumindest einen ersten Systemparameters und des zumindest einen zweiten Systemparameters zu den weiteren Systemparametern angewendet wird. Dadurch kann eine Kompatibilität einer Kombination des ersten Systemparameters und des zweiten Systemparameters mit den weiteren Systemparametern bestimmt werden.

Gemäß einer weiteren bevorzugten Weiterbildung der Erfindung ist vorgesehen, dass der regelbasierte Algorithmus die weiteren Systemparameter, zu welchen eine Kompatibilität mit dem zumindest einen ersten Systemparameter und dem zumindest einen zweiten Systemparameter besteht, ausgibt. Ein Nutzer kann somit basierend auf dem Ausgabeergebnis die Testausführung durchführen oder alternativ eine weitere Einschränkung bzw. Selektion von Systemparametern vornehmen.

Gemäß einer weiteren bevorzugten Weiterbildung der Erfindung ist vorgesehen, dass in Reaktion auf das Ausgeben der weiteren Systemparameter durch den regelbasierten Algorithmus, zu welchen eine Kompatibilität mit dem zumindest einen ersten Systemparameter und dem zumindest einen zweiten Systemparameter besteht, zumindest ein dritter Systemparameter aus der Gruppe der weiteren Systemparameter für die Testausführung des virtuellen Tests selektiert wird. Somit kann in vorteilhafter Weise eine weitere Eingrenzung der Systemparameter einer spezifischen Testkonfiguration ermöglicht werden.

Gemäß einer weiteren bevorzugten Weiterbildung der Erfindung ist vorgesehen, dass der regelbasierte Algorithmus auf den bereitgestellten und/oder selektierten zumindest einen ersten Systemparameter, den selektierten zumindest einen zweiten Systemparameter und den selektierten zumindest einen dritten Systemparameter für die Testausführung des virtuellen Tests zum Bestimmen einer Kompatibilität des zumindest einen ersten Systemparameters, des zumindest einen zweiten Systemparameters und des zumindest einen dritten Systemparameters zu weiteren Systemparametern angewendet wird.

Dadurch kann eine Kompatibilität einer Kombination des ersten Systemparameters, des zweiten Systemparameters und des dritten Systemparameters mit den weiteren Systemparametern bestimmt werden.

Gemäß einer weiteren bevorzugten Weiterbildung der Erfindung ist vorgesehen, dass der regelbasierte Algorithmus die weiteren Systemparameter, zu welchen eine Kompatibilität mit dem zumindest einen ersten Systemparameter, dem zumindest einen zweiten Systemparameter und dem zumindest einen dritten Systemparameter besteht, ausgibt. Der Nutzer kann somit basierend auf dem Ausgabeergebnis die Testausführung durchführen oder alternativ eine weitere Einschränkung bzw. Selektion von Systemparametern vornehmen.

Gemäß einer weiteren bevorzugten Weiterbildung der Erfindung ist vorgesehen, dass der regelbasierte Algorithmus zum Bestimmen der Kompatibilität des zumindest einen ersten Systemparameters zu den weiteren Systemparametern eine, insbesondere auf einem Server zentral verwaltete, Datenbank abfragt, in welcher eine Kompatibilitätsdefinition des zumindest einen ersten Systemparameters zu den weiteren Systemparametern hinterlegt ist. Dadurch kann in vorteilhafter Weise eine Kompatibilität der jeweiligen Systemparameter zueinander bestimmt werden.

Gemäß einer weiteren bevorzugten Weiterbildung der Erfindung ist vorgesehen, dass auf Basis der bestimmten Kompatibilität der Systemparameter die Testausführung des virtuellen Tests der Vorrichtung zur zumindest teilweisen autonomen Führung des Kraftfahrzeugs unter Verwendung der selektierten Systemparameter konfiguriert wird. Hierdurch kann in vorteilhafter Weise eine fehlerfreie Testausführung ermöglicht werden.

Die hierin beschriebenen Merkmale des computerimplementierten Verfahrens zum Bestimmen einer Kompatibilität von Systemparametern für eine Testausführung eines virtuellen Tests einer Vorrichtung zur zumindest teilweisen autonomen Führung eines Kraftfahrzeugs sind ebenso auf das System zum Bestimmen einer Kompatibilität von Systemparametern für eine Testausführung eines virtuellen Tests einer Vorrichtung zur zumindest teilweisen autonomen Führung eines Kraftfahrzeugs und umgekehrt anwendbar.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: ein Ablaufdiagramm eines computerimplementierten Verfahrens zum Bestimmen einer Kompatibilität von Systemparametern für eine Testausführung eines virtuellen Tests einer Vorrichtung zur zumindest teilweisen autonomen Führung eines Kraftfahrzeugs;
- Fig. 2: eine tabellarische Darstellung einer Kompatibilitätsdefinition von Systemparametern für die Testausführung des virtuellen Tests der Vorrichtung zur zumindest teilweisen autonomen Führung des Kraftfahrzeugs; und
- Fig. 3: eine schematische Darstellung eines Systems zum Bestimmen der Kompatibilität von Systemparametern für die Testausführung des virtuellen Tests der Vorrichtung zur zumindest teilweisen autonomen Führung des Kraftfahrzeugs.

Sofern nicht anders angegeben, bezeichnen gleiche Bezugszeichen gleiche Elemente der Zeichnungen.

### Ausführliche Beschreibung der Ausführungsformen

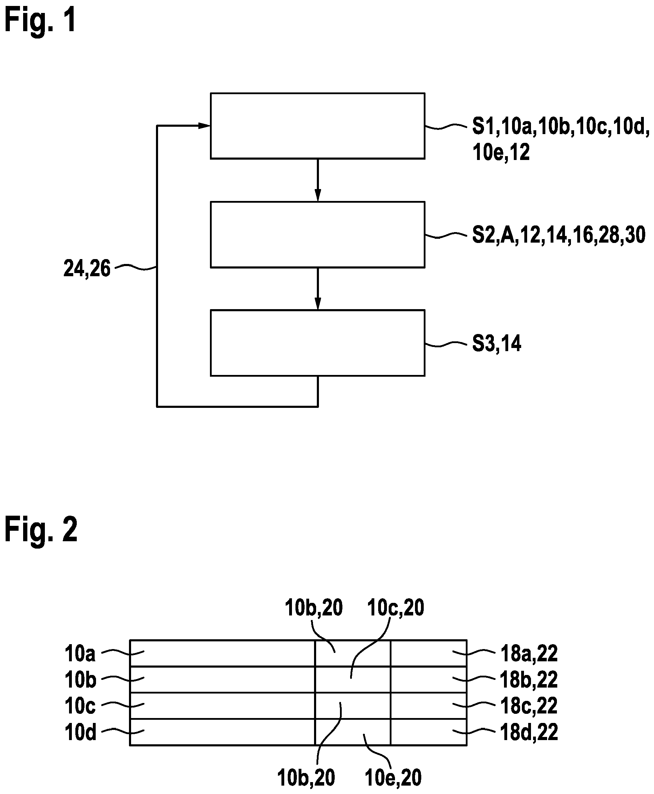

Das in Fig. 1 gezeigte Verfahren umfasst ein Bereitstellen S1 einer vorerfassten Selektion oder Selektieren zumindest eines, ein zu testendes System 10a, eine Testumgebung 10b, ein Testsystem 10c, ein Testszenario 10d und/oder einen zu testenden Fahrzeugtyp 10e für die Testausführung des virtuellen Tests bezeichnenden ersten Systemparameters 12.

Des Weiteren umfasst das Verfahren ein Anwenden S2 eines regelbasierten Algorithmus A auf den zumindest einen ersten Systemparameter 12 zum Bestimmen einer Kompatibilität des zumindest einen ersten Systemparameters 12 zu zumindest einem weiteren Systemparameter 14 aus einer Gruppe aufweisend das zu testende System 10a, die Testumgebung 10b, das Testsystem 10c, das Testszenario 10d und/oder den zu testenden Fahrzeugtyp 10e. Der regelbasierte Algorithmus A bestimmt dabei die Kompatibilität auf Basis einer den virtuellen Test der Vorrichtung 8 zur zumindest teilweisen autonomen Führung des Kraftfahrzeugs ausführenden und/oder Testdaten bereitstellenden Hardware- und/oder Softwarekomponente 16.

Darüber hinaus umfasst das Verfahren ein Ausgeben S3 des zumindest einen weiteren Systemparameters 14, zu welchem die Kompatibilität mit dem zumindest einen ersten Systemparameter 12 besteht.

Das zu testende System 10a ist ein computerimplementiertes Verfahren zur Durchführung des virtuellen Tests der Vorrichtung 8 zur zumindest teilweisen autonomen Führung des Kraftfahrzeugs und die Testumgebung 10b ist durch Software- und/oder Hardwarebestandteile der Testumgebung 10b gebildet.

Die den virtuellen Test der Vorrichtung 8 zur zumindest teilweisen autonomen Führung des Kraftfahrzeugs ausführende und/oder Testdaten bereitstellende Hardware- und/oder Softwarekomponente 16 ist ein Sensortyp, insbesondere ein Kamerasensor, ein Radarsensor, ein LiDAR-Sensor, ein Ultraschallsensor, ein Regensensor und/oder ein Helligkeitssensor, eine Prozessorart, insbesondere eine CPU oder GPU, und eine Art des Testsystems 10c.

In Reaktion auf das Ausgeben S3 des zumindest einen, weiteren Systemparameters 14 durch den regelbasierten Algorithmus A, zu welchen eine Kompatibilität mit dem zumindest einen ersten Systemparameter 12 besteht, wird des Weiteren zumindest ein zweiter Systemparameter 24 aus der Gruppe der weiteren Systemparameter 14 für die Testausführung des virtuellen Tests selektiert.

Der regelbasierte Algorithmus A wird auf den bereitgestellten und/oder selektierten zumindest einen ersten Systemparameter 12 und den selektierten zumindest einen zweiten Systemparameter 24 für die Testausführung des virtuellen Tests zum Bestimmen einer Kompatibilität des zumindest einen ersten Systemparameters 12 und des zumindest einen zweiten Systemparameters 24 zu den weiteren Systemparametern 14 angewendet.

Der regelbasierte Algorithmus A gibt ferner die weiteren Systemparameter 14, zu welchen eine Kompatibilität mit dem zumindest einen ersten Systemparameter 12 und dem zumindest einen zweiten Systemparameter 24 besteht, aus. In Reaktion auf das Ausgeben der weiteren Systemparameter 14 durch den regelbasierten Algorithmus A, zu welchen eine Kompatibilität mit dem zumindest einen ersten Systemparameter 12 und dem zumindest einen zweiten Systemparameter 24 besteht, wird ferner zumindest ein dritter Systemparameter 26 aus der Gruppe der weiteren Systemparameter 14 für die Testausführung des virtuellen Tests selektiert.

Der regelbasierte Algorithmus A wird dabei auf den bereitgestellten und/oder selektierten zumindest einen ersten Systemparameter 12, den selektierten zumindest einen zweiten Systemparameter 24 und den selektierten zumindest einen dritten Systemparameter 26 für die Testausführung des virtuellen Tests zum Bestimmen einer Kompatibilität des zumindest einen ersten Systemparameters 12, des zumindest einen zweiten Systemparameters 24 und des zumindest einen dritten Systemparameters 26 zu weiteren Systemparametern 14 angewendet.

Der regelbasierte Algorithmus A gibt sodann die weiteren Systemparameter 14, zu welchen eine Kompatibilität mit dem zumindest einen ersten Systemparameter 12, dem zumindest einen zweiten Systemparameter 24 und dem zumindest einen dritten Systemparameter 26 besteht, aus.

Der regelbasierte Algorithmus A fragt zum Bestimmen der Kompatibilität des zumindest einen ersten Systemparameters 12 zu den weiteren Systemparametern 14 ferner eine, insbesondere auf einem Server 28 zentral verwaltete, Datenbank 30 ab. In der Datenbank 30 ist eine Kompatibilitätsdefinition des zumindest einen ersten Systemparameters 12 zu den weiteren Systemparametern 14 hinterlegt.

Auf Basis der bestimmten Kompatibilität der Systemparameter 12, 14, 24, 26 wird die Testausführung des virtuellen Tests der Vorrichtung 8 zur zumindest teilweisen autonomen Führung des Kraftfahrzeugs unter Verwendung der selektierten Systemparameter konfiguriert.

Fig. 2 zeigt eine tabellarische Darstellung einer Kompatibilitätsdefinition von Systemparametern für die Testausführung des virtuellen Tests der Vorrichtung zur zumindest teilweisen autonomen Führung des Kraftfahrzeugs.

Das zu testende System 10a, die Testumgebung 10b, das Testsystem 10c, das Testszenario 10d und/oder der zu testende Fahrzeugtyp 10e ist jeweils durch eine Mehrzahl von Kategorien 18a, 18b, 18c, 18d von Systemkomponenten und/oder Systemeigenschaften definiert. Jede dem zu testenden System, der Testumgebung 10b, dem Testsystem 10c, dem Testszenario 10d und/oder dem zu testenden Fahrzeugtyp 10e zugeordnete Kategorie 18a, 18b, 18c, 18d von Systemkomponenten und/oder Systemeigenschaften zumindest weist eine die Systemkomponente und/oder die Systemeigenschaft identifizierende Bezeichnung, insbesondere eine alphabetische und/oder numerische Bezeichnung, auf.

Eine Kompatibilität des zumindest einen ersten (in Fig. 1 gezeigten) Systemparameters 12 zu dem zumindest einen, weiteren Systemparameter 14 ist durch Übereinstimmung zumindest einer, die Systemkomponente und/oder die Systemeigenschaft identifizierenden ersten Bezeichnung 20 mit einer zweiten, die Systemkomponente und/oder die Systemeigenschaft identifizierenden zweiten Bezeichnung 22 gegeben. Das zu testende System 10a erfordert ferner eine Verfügbarkeit vorgegebener Rechenressourcen und/oder Sensortypen.

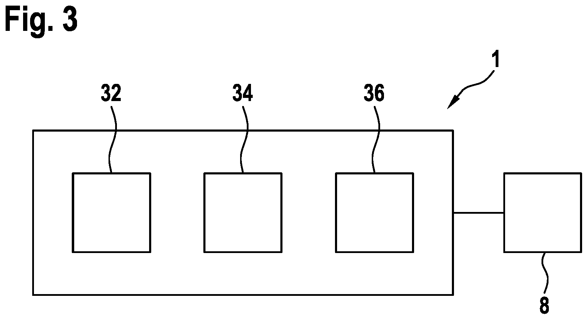

Fig. 3 zeigt eine schematische Darstellung eines Systems 1 zum Bestimmen der Kompatibilität von Systemparametern für die Testausführung des virtuellen Tests der Vorrichtung zur zumindest teilweisen autonomen Führung des Kraftfahrzeugs gemäß der bevorzugten Ausführungsform der Erfindung.

Das System 1 umfasst Mittel 32 zum Bereitstellen einer vorerfassten Selektion oder Selektieren zumindest eines, ein zu testendes System 10a, eine Testumgebung 10b, ein Testsystem 10c, ein Testszenario 10d und/oder einen zu testenden Fahrzeugtyp 10e für die Testausführung des virtuellen Tests bezeichnenden ersten Systemparameters 12.

Des Weiteren umfasst das System 1 Mittel 34 zum Anwenden eines regelbasierten Algorithmus A auf den zumindest einen ersten Systemparameter 12 zum Bestimmen einer Kompatibilität des zumindest einen ersten Systemparameters 12 zu zumindest einem weiteren Systemparameter 14 aus einer Gruppe aufweisend das zu testende System 10a, die Testumgebung 10b, das Testsystem 10c, das Testszenario 10d und/oder den zu testenden Fahrzeugtyp 10e, wobei der regelbasierte Algorithmus A die Kompatibilität auf Basis einer den virtuellen Test der Vorrichtung 8 zur zumindest teilweisen autonomen Führung des Kraftfahrzeugs ausführenden und/oder Testdaten bereitstellenden Hardware- und/oder Softwarekomponente 16 bestimmt.

Darüber hinaus umfasst das System 1 Mittel 36 zum Ausgeben des zumindest einen weiteren Systemparameters 14, zu welchem die Kompatibilität mit dem zumindest einen ersten Systemparameter 12 besteht.

### Bezugszeichenliste

- 1: System
- 8: Vorrichtung
- 10a: zu testendes System
- 10b: Testumgebung
- 10c: Testsystem
- 10d: Testszenario
- 10e: Fahrzeugtyp
- 12: erster Systemparameter
- 14: weitere Systemparameter
- 16: Hardware- und/oder Softwarekomponente
- 18a, 18b: Kategorie
- 18c, 18d: Kategorie
- 20: erste Bezeichnung
- 22: zweite Bezeichnung
- 24: zweiter Systemparameters
- 26: dritter Systemparameter
- 28: Server
- 30: Datenbank
- 32, 34, 36: Mittel
- A: regelbasierter Algorithmus
- S1-S3: Verfahrensschritte

## Patentansprüche

1. Computerimplementiertes Verfahren zum Bestimmen einer Kompatibilität von Systemparametern (12, 14, 24, 26) für eine Testausführung eines virtuellen Tests einer Vorrichtung (8) zur zumindest teilweisen autonomen Führung eines Kraftfahrzeugs, mit den Schritten:
Bereitstellen (S1) einer vorerfassten Selektion oder Selektieren zumindest eines, ein zu testendes System (10a), eine Testumgebung (10b), ein Testsystem (10c), ein Testszenario (10d) und/oder einen zu testenden Fahrzeugtyp (10e) für die Testausführung des virtuellen Tests bezeichnenden ersten Systemparameters (12);
Anwenden (S2) eines regelbasierten Algorithmus (A) auf den zumindest einen ersten Systemparameter (12) zum Bestimmen einer Kompatibilität des zumindest einen ersten Systemparameters (12) zu zumindest einem weiteren Systemparameter (14) aus einer Gruppe aufweisend das zu testende System (10a), die Testumgebung (10b), das Testsystem (10c), das Testszenario (10d) und/oder den zu testenden Fahrzeugtyp (10e), wobei der regelbasierte Algorithmus (A) die Kompatibilität auf Basis einer den virtuellen Test der Vorrichtung (8) zur zumindest teilweisen autonomen Führung des Kraftfahrzeugs ausführenden und/oder Testdaten bereitstellenden Hardware- und/oder Softwarekomponente (16) bestimmt; und
Ausgeben (S3) des zumindest einen weiteren Systemparameters (14), zu welchem die Kompatibilität mit dem zumindest einen ersten Systemparameter (12) besteht.

2. Computerimplementiertes Verfahren nach Anspruch 1, wobei das zu testende System (10a) ein computerimplementiertes Verfahren zur Durchführung des virtuellen Tests der Vorrichtung (8) zur zumindest teilweisen autonomen Führung des Kraftfahrzeugs ist und die Testumgebung (10b) durch Software- und/oder Hardwarebestandteile der Testumgebung (10b) gebildet ist.

3. Computerimplementiertes Verfahren nach Anspruch 1 oder 2, wobei die den virtuellen Test der Vorrichtung (8) zur zumindest teilweisen autonomen Führung des Kraftfahrzeugs ausführende und/oder Testdaten bereitstellende Hardware- und/oder Softwarekomponente (16) ein Sensortyp, insbesondere ein Kamerasensor, ein Radarsensor, ein LiDAR-Sensor, ein Ultraschallsensor, ein Regensensor und/oder ein Helligkeitssensor, eine Prozessorart, insbesondere eine CPU oder GPU, und eine Art des Testsystems (10c) ist.

4. Computerimplementiertes Verfahren nach einem der vorhergehenden Ansprüche, wobei das zu testende System (10a), die Testumgebung (10b), das Testsystem (10c), das Testszenario (10d) und/oder der zu testende Fahrzeugtyp (10e) jeweils durch eine Mehrzahl von Kategorien (18a, 18b, 18c, 18d) von Systemkomponenten und/oder Systemeigenschaften definiert sind, wobei jede dem zu testenden System, der Testumgebung (10b), dem Testsystem (10c), dem Testszenario (10d) und/oder dem zu testenden Fahrzeugtyp (10e) zugeordnete Kategorie (18a, 18b, 18c, 18d) von Systemkomponenten und/oder Systemeigenschaften zumindest eine die Systemkomponente und/oder die Systemeigenschaft identifizierende Bezeichnung, insbesondere eine alphabetische und/oder numerische Bezeichnung, aufweist.

5. Computerimplementiertes Verfahren nach Anspruch 4, wobei eine Kompatibilität des zumindest einen ersten Systemparameters (12) zu dem zumindest einen, weiteren Systemparameter (14) durch Übereinstimmung zumindest einer, die Systemkomponente und/oder die Systemeigenschaft identifizierenden ersten Bezeichnung (20) mit einer zweiten, die Systemkomponente und/oder die Systemeigenschaft identifizierenden zweiten Bezeichnung (22) gegeben ist.

6. Computerimplementiertes Verfahren nach einem der Ansprüche 2 bis 5, wobei das zu testende System (10a) eine Verfügbarkeit vorgegebener Rechenressourcen und/oder Sensortypen erfordert.

7. Computerimplementiertes Verfahren nach einem der vorhergehenden Ansprüche, wobei in Reaktion auf das Ausgeben (S3) des zumindest einen, weiteren Systemparameters (14) durch den regelbasierten Algorithmus (A), zu welchen eine Kompatibilität mit dem zumindest einen ersten Systemparameter (12) besteht, zumindest ein zweiter Systemparameter (24) aus der Gruppe der weiteren Systemparameter (14) für die Testausführung des virtuellen Tests selektiert wird.

8. Computerimplementiertes Verfahren nach Anspruch 7, wobei der regelbasierte Algorithmus (A) auf den bereitgestellten und/oder selektierten zumindest einen ersten Systemparameter (12) und den selektierten zumindest einen zweiten Systemparameter (24) für die Testausführung des virtuellen Tests zum Bestimmen einer Kompatibilität des zumindest einen ersten Systemparameters (12) und des zumindest einen zweiten Systemparameters (24) zu den weiteren Systemparametern (14) angewendet wird.

9. Computerimplementiertes Verfahren nach Anspruch 8, wobei der regelbasierte Algorithmus (A) die weiteren Systemparameter (14), zu welchen eine Kompatibilität mit dem zumindest einen ersten Systemparameter (12) und dem zumindest einen zweiten Systemparameter (24) besteht, ausgibt.

10. Computerimplementiertes Verfahren nach Anspruch 9, wobei in Reaktion auf das Ausgeben der weiteren Systemparameter (14) durch den regelbasierten Algorithmus (A), zu welchen eine Kompatibilität mit dem zumindest einen ersten Systemparameter (12) und dem zumindest einen zweiten Systemparameter (24) besteht, zumindest ein dritter Systemparameter (26) aus der Gruppe der weiteren Systemparameter (14) für die Testausführung des virtuellen Tests selektiert wird.

11. Computerimplementiertes Verfahren nach Anspruch 10, wobei der regelbasierte Algorithmus (A) auf den bereitgestellten und/oder selektierten zumindest einen ersten Systemparameter (12), den selektierten zumindest einen zweiten Systemparameter (24) und den selektierten zumindest einen dritten Systemparameter (26) für die Testausführung des virtuellen Tests zum Bestimmen einer Kompatibilität des zumindest einen ersten Systemparameters (12), des zumindest einen zweiten Systemparameters (24) und des zumindest einen dritten Systemparameters (26) zu weiteren Systemparametern (14) angewendet wird.

12. Computerimplementiertes Verfahren nach Anspruch 11, wobei der regelbasierte Algorithmus (A) die weiteren Systemparameter (14), zu welchen eine Kompatibilität mit dem zumindest einen ersten Systemparameter (12), dem zumindest einen zweiten Systemparameter (24) und dem zumindest einen dritten Systemparameter (26) besteht, ausgibt.

13. Computerimplementiertes Verfahren nach einem der vorhergehenden Ansprüche, wobei der regelbasierte Algorithmus (A) zum Bestimmen der Kompatibilität des zumindest einen ersten Systemparameters (12) zu den weiteren Systemparametern (14) eine, insbesondere auf einem Server (28) zentral verwaltete, Datenbank (30) abfragt, in welcher eine Kompatibilitätsdefinition des zumindest einen ersten Systemparameters (12) zu den weiteren Systemparametern (14) hinterlegt ist.

14. Computerimplementiertes Verfahren nach einem der vorhergehenden Ansprüche, wobei auf Basis der bestimmten Kompatibilität der Systemparameter (12, 14, 24, 26) die Testausführung des virtuellen Tests der Vorrichtung (8) zur zumindest teilweisen autonomen Führung des Kraftfahrzeugs unter Verwendung der selektierten Systemparameter konfiguriert wird.

15. System (1) zum Bestimmen einer Kompatibilität von Systemparametern (12, 14, 24, 26) für eine Testausführung eines virtuellen Tests einer Vorrichtung (8) zur zumindest teilweisen autonomen Führung eines Kraftfahrzeugs, umfassend:
Mittel (32) zum Bereitstellen einer vorerfassten Selektion oder Selektieren zumindest eines, ein zu testendes System (10a), eine Testumgebung (10b), ein Testsystem (10c), ein Testszenario (10d) und/oder einen zu testenden Fahrzeugtyp (10e) für die Testausführung des virtuellen Tests bezeichnenden ersten Systemparameters (12);
Mittel (34) zum Anwenden eines regelbasierten Algorithmus (A) auf den zumindest einen ersten Systemparameter (12) zum Bestimmen einer Kompatibilität des zumindest einen ersten Systemparameters (12) zu zumindest einem weiteren Systemparameter (14) aus einer Gruppe aufweisend das zu testende System (10a), die Testumgebung (10b), das Testsystem (10c), das Testszenario (10d) und/oder den zu testenden Fahrzeugtyp (10e), wobei der regelbasierte Algorithmus (A) die Kompatibilität auf Basis einer den virtuellen Test der Vorrichtung (8) zur zumindest teilweisen autonomen Führung des Kraftfahrzeugs ausführenden und/oder Testdaten bereitstellenden Hardware- und/oder Softwarekomponente (16) bestimmt; und
Mittel (36) zum Ausgeben des zumindest einen weiteren Systemparameters (14), zu welchem die Kompatibilität mit dem zumindest einen ersten Systemparameter (12) besteht.
